# EUROPEAN PATENT SPECIFICATION

(11) **EP 4 235 904 B1**
(45) Date of publication and mention of the grant of the patent: **26.08.2026**
(21) Application number: 22890237.5
(22) Date of filing: 21.10.2022
(51) Int. Cl.: H01M 10/42, G01R 31/52, H01M 10/058

(54) **SECONDARY BATTERY FOR TESTING SHORT CIRCUIT, METHOD OF MANUFACTURING THE SECONDARY BATTERY, AND METHOD OF EVALUATING SAFETY OF SECONDARY BATTERY**
SEKUNDÄRBATTERIE ZUR PRÜFUNG EINES KURZSCHLUSSES, VERFAHREN ZUR HERSTELLUNG DER SEKUNDÄRBATTERIE UND VERFAHREN ZUR BEWERTUNG DER SICHERHEIT DER SEKUNDÄRBATTERIE
BATTERIE SECONDAIRE POUR TESTER UN COURT-CIRCUIT, PROCÉDÉ DE FABRICATION DE LA BATTERIE SECONDAIRE ET PROCÉDÉ D'ÉVALUATION DE LA SÉCURITÉ DE LA BATTERIE SECONDAIRE

(30) Priority: 02.11.2021 KR 20210148572
(43) Date of publication of application: 30.08.2023
(73) Proprietor: LG Energy Solution, Ltd., Seoul 07335 (KR)
(72) Inventor: YOON, Dong Sik, Daejeon 34122 (KR)
(74) Representative: Hoffmann Eitle
(86) International application number: PCT/KR2022/016104
(87) International publication number: WO 2023/080502

(56) References cited:
- JP-A- 2017 182 976
- KR-A- 20130 030 807
- KR-A- 20200 053 782
- KR-A- 20200 118 958
- KR-A- 20210 017 178

## Description

### [Technical Field]

The present disclosure relates to a secondary battery for testing short circuit, a method of manufacturing the secondary battery, and a method of evaluating safety of the secondary battery.

### [Background Art]

As the prices of energy sources increase due to depletion of fossil fuels and interest in environmental pollution increases, the demand for environmentally friendly alternative energy sources is becoming an indispensable factor for life in the future. In particular, as technology development and the demand for mobile devices increase, the demand for secondary batteries as energy sources is rapidly increasing.

Typically, in terms of shapes of batteries, there is a high demand for prismatic secondary batteries and pouch type secondary batteries that can be applied to products such as mobile phones due to their small thickness. In terms of materials, there is a high demand for lithium secondary batteries such as lithium ion batteries and lithium ion polymer batteries having high energy density, discharge voltage, and output stability.

Generally, a secondary battery is manufactured by applying an electrode mixture including an electrode active material on a surface of a current collector to form a positive electrode and a negative electrode, inserting a separator between the positive electrode and the negative electrode to manufacture an electrode assembly, mounting the electrode assembly in a cylindrical or rectangular metal can or a pouch type case of an aluminum laminate sheet, and then injecting or impregnating a liquid electrolyte into the electrode assembly or using a solid electrolyte.

In addition, secondary batteries may be classified according to a structure of an electrode assembly having a positive electrode/separator/negative electrode structure. Representative examples thereof may include a jelly-roll type (wound type) electrode assembly having a structure in which long sheet-like positive electrodes and negative electrodes are wound with a separator interposed therebetween, a stack type electrode assembly having a structure in which a plurality of positive electrodes and negative electrodes cut to a certain size unit are sequentially stacked with a separator interposed therebetween, and a stack/folding type electrode assembly having a structure in which bi-cells or full cells in which positive electrodes and negative electrodes are stacked in a certain unit with a separator interposed therebetween are wound with a separator sheet.

Meanwhile, an electrode generates a current through the exchange of ions, and a positive electrode and a negative electrode constituting the electrode has a structure in which an electrode active material is applied on an electrode current collector made of a metal. In general, the negative electrode has a structure in which a carbon-based active material is applied on an electrode plate made of copper, aluminum, or the like and a positive electrode has a structure in which an active material made of LiCoO₂, LiMnO₂, LiNiO₂, or the like is applied on an electrode plate made of aluminum or the like.

In order to manufacture such a positive or negative electrode, an electrode mixture including an electrode active material is applied on an electrode current collector made of a long metal sheet in one direction.

A separator is positioned between a positive electrode and a negative electrode of a battery to insulate the positive electrode and the negative electrode and maintain an electrolyte to provide a passage for ion conduction.

Such a secondary battery is a rechargeable battery that is manufactured using a material in which a redox process between a current and the material is repeated multiple times. When a reduction reaction is performed on the material by the current, power is charged. Also, when an oxidation reaction is performed on the material, power is discharged. Such charging/discharging is repeatedly performed to generate electricity.

Lithium secondary batteries have excellent electrical properties but have a problem of low safety. For example, in an abnormal operating state such as overcharge, overdischarge, exposure to a high temperature, or an electrical short circuit, lithium secondary batteries generate heat and gas due to a decomposition reaction of active materials and electrolytes which are battery components, and thus the resulting high temperature and high pressure conditions further promote a decomposition reaction and sometimes cause a fire or explosion.

In addition, it is very important to secure safety even when an internal short circuit occurs in a battery, and for this purpose, it is important to correctly evaluate safety of the battery when an internal short circuit occurs. Battery tests for evaluating exothermic behavior under an internal short circuit condition as a safety item of batteries such as lithium ion secondary batteries are defined, for example, by UL standards for lithium batteries (UL1642) and Standards of Battery Association of Japan (SBA G1101-1997 lithium secondary battery safety evaluation standard guidelines).

Conventionally, there are a method of inserting a heating element into a battery cell to induce an internal short circuit and generating internal heat using the heating element, a method of pre-drilling an internal separator and treating the drilled portion with chemicals to melt the portion at a certain temperature, and a method of inserting a certain type of a metal material and applying an external force to tear a separator and induce an internal short circuit. However, in the case of the first method, a shape is different from that of an actual product due to a heating element inside a cell and an external heating source. In the case of the second method, it is necessary to deform an actually used separator and chemical treatment is performed on a damaged portion of a separator, and thus characteristics may be different from those of existing products, and a desired reaction may not occur due to side reactions caused by a chemical reaction inside a cell.

Meanwhile, as an internal short circuit induction device of a battery, US Patent Publication No. 2013-0209841 discloses an inside short circuit induction device of a battery cell in which, after a separator is perforated, a copper plate is inserted into a battery cell, copper and aluminum plates are placed on both surfaces of the separator, and then a wax layer is installed between the copper plate and the separator or between the aluminum plate and the separator. When a temperature rises above a melting point of the wax layer in the internal short circuit induction device, the wax layer is removed, and a positive electrode and a negative electrode are electrically connected by the copper and aluminum plates to cause an internal short circuit. However, such a method has a problem in that a manufacturing process of the internal short circuit induction device is complicated, costs are high, and the battery cell should be disassembled and reassembled for repeated use.

In addition, conventionally, in order to evaluate an internal short circuit during operating of a battery, a method of disassembling a battery that is fully charged or charged to a desired state of charge (SOC), inserting an internal short circuit induction device into an arbitrary short circuit region, and then reassembling the battery has been used. However, the method has problems in that the process of inserting the internal short circuit induction device or the reassembly process leads to risk factors, and a deviation occurs according to evaluation conditions, which makes it difficult to perform uniform evaluation. Moreover, existing internal short circuit induction devices cannot precisely implement a micro short circuit, and thus it is difficult to finely adjust a short circuit induction condition, which makes it impossible to perform a fine level precision test.

### [Disclosure]

### [Technical Problem]

An object of the present disclosure is to provide a test secondary battery for precisely testing an internal short circuit inside a battery at a fine level without physically deforming a battery cell structure, a method of manufacturing the secondary battery, and a method of evaluating safety of a battery using the secondary battery.

### [Technical Solution]

The present invention is set out in the appended claims and provides a secondary battery for testing short circuit. In addition, it provides a method of manufacturing a secondary battery for testing short circuit and a method of evaluating safety of a secondary battery.

### [Advantageous Effects]

In a secondary battery for testing short circuit of the present disclosure, a physical deformation problem of secondary batteries, which is the most serious problem of conventional methods, is solved, and without a process of disassembling and reassembling a separate secondary battery, a secondary battery for evaluation is manufactured using a separator including an internal short circuit induction member, thereby improving measurement precision. In addition, a micro short circuit can be accurately implemented by including a metal pattern layer so that an internal short circuit of a battery can be accurately evaluated at a microscopic level.

### [Brief Description of the Drawings]

FIG. 1 is a schematic side view illustrating a secondary battery for testing short circuit which includes a short circuit induction member according to one embodiment of the present disclosure.
FIG. 2 is a schematic side view illustrating the secondary battery for testing short circuit in a state in which an internal short circuit is induced under a certain condition in the secondary battery for testing short circuit which includes the short circuit induction member according to one embodiment of the present disclosure.
FIG. 3 shows schematic views sequentially illustrating processes of manufacturing a short circuit induction member according to one embodiment of the present disclosure.

### [Detailed Description of the Preferred Embodiments]

While the present invention is as set out in the appended claims, specific embodiments thereof will be described and illustrated by way of example in the accompanying drawings. However, this is not purported to limit the present invention to a specific disclosed form, but it shall be understood to include all modifications, equivalents and substitutes within the scope of the appended claims.

Like numbers refer to like elements throughout the description of the drawings. In the accompanying drawings, the dimensions of structures may be exaggerated to clarify the described technology. While terms such as "first," "second," and the like may be used to describe various components, such components must not be understood as being limited by the above terms. These terms are only used for the purpose of distinguishing one element from another element. For example, without departing from the scope of the present disclosure, a first component may be referred to as a second component, and likewise a second component may be referred to as a first component. A singular expression includes a plural expression unless the context clearly indicates otherwise.

In this application, it should be understood that terms such as "include" or "have" are intended to indicate that there is a feature, number, step, operation, component, part, or a combination thereof described on the specification, and they do not exclude in advance the possibility of the presence or addition of one or more other features or numbers, steps, operations, components, parts or combinations thereof. Also, when a portion such as a layer, a film, an area, a plate, etc. is referred to as being "on" another portion, this includes not only the case where the portion is "directly on" another portion but also the case where still another portion is interposed therebetween. On the other hand, when a portion such as a layer, a film, an area, a plate, etc. is referred to as being "under" another portion, this includes not only the case where the portion is "directly under" another portion but also the case where still another portion is interposed therebetween. In addition, the term "disposed on" in the present application may include a case of being disposed at the bottom as well as the top.

Hereinafter, the present disclosure will be described in detail.

An internal short circuit test is a test for evaluating resistance to an internal short circuit among safety tests of a battery and is a test simulated when a positive electrode and a negative electrode are short-circuited inside the battery. In the internal short circuit test, a fully charged evaluation battery is first provided, an internal short circuit is caused, and a behavior of the battery is evaluated. In general, when an internal short circuit occurs, a battery is discharged, and thus a voltage decreases. A test is performed until the voltage decreases below a certain value to evaluate the presence or absence of rupture and a voltage, temperature, and the like of the battery.

As an example of an internal short circuit induction device designed for evaluating safety of a battery, in the case of an internal short circuit induction device developed by US Energy Research Institute (NREL), an insulator made of a wax component is disposed between a positive electrode and a negative electrode to physically separate the positive electrode and the negative electrode. Then, when a battery is charged and discharged and an internal temperature of the battery rises to a melting point of wax, the wax is removed to bring the positive electrode and the negative electrode into direct contact with each other, thereby causing a short circuit inside the battery.

More specifically, in a conventional internal short circuit induction device, a separator is partially perforated to form a hole, a metal block made of copper or the like is inserted into the hole, and then a wax layer is disposed on one side surface of the metal block. The conventional internal short circuit induction device has a structure in which a positive plate is attached to a portion of the separator at which the wax layer is not disposed, and a negative plate is attached to the wax layer. The conventional internal short circuit induction device has a structure in which the wax layer is removed to bring a positive electrode, the block made of a metal, and a negative electrode into direct contact with each other, thereby causing a short circuit.

In lithium ion secondary batteries, as lithium ions move between a negative electrode and a positive electrode, a redox reaction occurs. However, as described above, since a process of inserting the conventional internal short circuit induction device into a battery for testing an internal short circuit and recombining the conventional internal short circuit is difficult, and the battery is disassembled and then recombined, it is difficult to simulate an exact behavior of the battery, it is impossible to conduct a uniform evaluation, and because a size of the internal short circuit induction device is standardized, it is impossible to precisely implement a micro short circuit. Thus, there has been a problem in that it is not possible to precisely test a micro internal short circuit.

A secondary battery for testing short circuit according to the present invention includes a positive electrode, a negative electrode, a separator between the positive electrode and the negative electrode, and a short circuit induction member on a region of one surface or both surfaces of the separator. Still according to the invention, the short circuit induction member has a structure including a metal pattern layer and an insulating layer, which is made of a C₁₆ to C₄₀ paraffin-based compound, applied on and covering the metal pattern layer.

The secondary battery for testing short circuit of the present disclosure includes the short circuit induction member therein, and the internal short circuit induction member serves as a kind of switch and is activated by an external mechanism such as an increase in temperature or pressure. That is, during a test process or actual use of the battery, the separator coupled to the short circuit induction member is deformed due to external pressure or a rise in temperature, when a temperature rises above a certain condition, the insulating layer melts and the positive electrode and the negative electrode are connected through the short circuit induction member, and thereby an internal short circuit is caused.

Meanwhile, the region on one surface or both surfaces of the separator is a test region which is a target for testing an internal short circuit of the secondary battery. A formation area of the short circuit induction member may be in a range of 1 µm² to 1,000 mm², 1 µm² to 100 mm², 1 µm² to 1 mm², 100 µm² to 100 mm², or 1 µm² to 100 µm². When the formation area of the short circuit induction member is smaller than the above range, there is a problem in that the difficulty of a manufacturing process of the short circuit induction member to be coupled to the corresponding area increases. On the other hand, when the formation area of the short circuit induction member is too large, an area of the separator including the short circuit induction member increases, and side reactions occur due to undesired chemical reactions inside the battery, which may make an accurate evaluation difficult. Meanwhile, the formation area may be appropriately changed according to a type and characteristics of a secondary battery and a purpose of testing a short circuit inside the secondary battery.

When the insulating layer melts, the metal pattern layer comes into contact with the positive electrode and the negative electrode to electrically connect the positive electrode and the negative electrode, thereby serving to induce an internal short circuit. That is, a pattern of the metal pattern layer may be formed through a fine patterning method. A pattern width of the metal pattern layer may be in a range of 1 nm to 100 µm. When the pattern width of the metal pattern layer is less than 1 nm, the difficulty of the fine patterning method may increase, which decreases manufacturing efficiency, and the metal pattern layer may be easily separated or deformed and be destroyed even by a weak external force. On the other hand, when the pattern width of the metal pattern layer exceeds 100 µm, it may be difficult to finely control a density of the metal pattern.

Next, a thickness of the metal pattern layer may be in a range of 1% to 200% of the pattern width of the metal pattern layer. When the thickness of the metal pattern layer is within the above range, even when at least one of heat or external pressure is applied, a structure of the short circuit induction member may be difficult to destroy, and an internal short circuit can be effectively caused. Meanwhile, the thickness of the metal pattern layer is a thickness from a point at which the metal pattern layer and the separator are in contact with each other. When the thickness of the metal pattern layer is less than 1% of the pattern width of the metal pattern layer, even when the insulating layer melts, it is difficult for the metal pattern layer to come into contact with the positive electrode and the negative electrode at the same time, and therefore a short circuit may not be smoothly caused. When the thickness of the metal pattern layer exceeds 200% of the pattern width of the metal pattern layer, a volume of the short circuit induction member may be increased, and a short circuit inside the battery may be caused even in a sensitive reaction.

Meanwhile, the metal pattern layer may be made of a metal material that does not react with components such as an electrolyte and has high electrical conductivity, may be made of a single metal selected from among aluminum, copper, and titanium, and may be made of an alloy including one or more selected from among the above metals. Preferably, the metal pattern layer may be made of aluminum or copper.

In addition, the metal pattern layer may be a single metal layer made of any one selected from among aluminum, copper, and titanium or a single layer of an alloy layer including one or more selected from among aluminum, copper, and titanium or may be a composite layer in which the metal layer and the alloy layer are stacked in multiple layers.

The insulating layer according to the invention is made of a C₁₆ to C₄₀ paraffin-based compound, and when the secondary battery reaches a certain temperature, the insulating layer easily melts and exposes the metal pattern layer covered by the insulating layer to induce an internal short circuit due to contact between the metal pattern layer and the positive and negative electrodes. When the secondary battery does not reach the certain temperature, the insulating layer serves as an insulator for preventing a short circuit during charging/discharging of the battery, thereby preventing a short circuit from being caused due to the negative electrode and the positive electrode being electrically connected through the metal pattern layer.

A thickness of the insulating layer may be in a range of 101% to 200% of the thickness of the metal pattern layer. When the thickness of the insulating layer is within the above range, a structure of the insulating layer may not be easily destroyed even when the short circuit induction member receives an external force, and thus the insulating layer may have structural stability.

The insulating layer may be a layer covering the metal pattern layer and may have the thickness that is greater than or equal to the thickness of the metal pattern layer. When the thickness of the insulating layer is less than 101% of the thickness of the metal pattern layer, the metal pattern layer cannot be sufficiently covered, and even when a small amount of heat is supplied, the insulating layer easily melts and exposes the metal pattern layer. Thus, an undesired internal short circuit may be caused. On the other hand, when the thickness of the insulating layer exceeds 200% of the thickness of the metal pattern layer, a volume of the short circuit induction member may increase, due to heat being continuously supplied to melt the insulating layer, chemical reactions may occur inside a battery and cause undesired side reactions, insulating layer material that hinders a short circuit from being caused may partially remain, and an evaluation may take much time.

A material of the insulating layer is according to the invention a C₁₆ to C₄₀ paraffin-based compound in consideration of a melting temperature.

Paraffin may be sensitive to heat generation, and may melt to cause a short circuit inside a battery and also quickly lower a temperature of the battery. In addition, paraffin has an advantage of not causing side effects such as degradation in performance of the battery or reduction in capacity thereof.

In general, paraffin collectively refers to paraffin wax or liquid paraffin including paraffin-based hydrocarbons, and such materials have weak reactivity and are resistant to chemicals. The paraffin wax is a colorless translucent solid and is also referred to as solid paraffin, and the liquid paraffin is a colorless liquid. In the present disclosure, since the insulating layer is present in a solid state to electrically insulate the negative electrode and the positive electrode, paraffin wax, which is solid paraffin, can be used.

A main component of paraffin wax is a straight-chain paraffin-based hydrocarbon, which may be represented by CH₃(CH₂)ₙCH₃. Here, the number of carbon atoms is in a range of 16 to 40 when according to the invention, and C₂₀ to C₃₀ paraffin-based hydrocarbon is the main component. A melting point of paraffin wax may be in a range of about 47 °C to 65 °C and may be changed according to a degree of purification, components, and the like. Paraffin contained in a paraffin sheet absorbs ambient heat to melt, thereby serving to prevent overheating. Therefore, in consideration of heat of melting, it is possible to use paraffin having a melting point suitable for need.

In particular, since paraffin according to the present disclosure exhibits high fluidity (low viscosity) when melted, when a temperature of a battery rises, the paraffin may easily melt to cause an internal short circuit.

In addition, the insulating layer may further include other additives within a range that does not impair physical properties of paraffin and does not affect an operating mechanism of a battery so that performance such as meltability of the insulating layer can be improved.

Meanwhile, a melting temperature of the insulating layer is determined according to components or a composition of the C₁₆ to C₄₀ paraffin-based compound constituting the insulating layer, is preferably in a range of 40 °C to 80 °C, and is more preferably in a range of 50 °C to 70 °C. When a temperature at which an internal short circuit occurs is less than 40 °C, an undesirable internal short circuit may occur at a temperature at which a battery is actually used. When a temperature at which an internal short circuit occurs exceeds 80 °C, since an abnormality due to a side reaction occurs inside a battery before an internal short circuit occurs, it is difficult to obtain an effect of a pure internal short circuit.

Hereinafter, a configuration of a secondary battery for testing short circuit of the present disclosure will be described. Specifically, the secondary battery for testing short circuit of the present disclosure may be used without limitation on the form of a battery such as a cylindrical battery, a pouch-type battery, a prismatic battery, or a coin-type battery.

The secondary battery includes an electrode assembly, and the electrode assembly has a structure in which a negative electrode and a positive electrode are alternately stacked with a separator interposed between the electrodes and are impregnated in a lithium salt-containing non-aqueous electrolyte. The electrode for a secondary battery may be manufactured by applying an electrode mixture including an electrode active material on a current collector and then drying the electrode mixture. If necessary, the electrode mixture may optionally further include a binder, a conductive material, a filler, and the like.

In the present disclosure, a positive electrode current collector is generally formed to have a thickness of 3 µm to 500 µm. A material of the positive electrode current collector is not particularly limited as long as the material has high conductivity without causing a chemical change in a battery, and for example, stainless steel, aluminum, nickel, titanium, or calcined carbon, or copper or stainless steel surface-treated with carbon, nickel, titanium, or silver may be used. A fine unevenness may be formed on a surface of a current collector to increase adhesion of a positive electrode active material, and the current collector may have any of various forms such as a film, a sheet, a foil, a net, a porous body, a foam body, a non-woven fabric body, and the like.

A sheet for a negative electrode current collector is generally formed to have a thickness of 3 µm to 500 µm. A material of the negative electrode current collector is not particularly limited as long as the material has high conductivity without causing a chemical change in a battery, and for example, stainless steel, aluminum, nickel, titanium, or calcined carbon, or copper or stainless steel surface-treated with carbon, nickel, titanium, or silver, or an aluminum-cadmium alloy may be used. In addition, like the positive electrode current collector, a fine unevenness may be formed on a surface of the negative electrode current collector to increase a bonding force of a negative electrode active material, and the negative electrode current collector may be used in any of various forms such as a film, a sheet, a foil, a net, a porous body, a foam body, a non-woven fabric body, and the like.

In the present disclosure, the positive electrode active material is a material capable of causing an electrochemical reaction, is a lithium transition metal oxide, and includes two or more transition metals. Examples thereof include a layered compound such as lithium cobalt oxide (LiCoO₂) or lithium nickel oxide (LiNiO₂) substituted with one or more transition metals, lithium manganese oxide substituted with one or more transition metals, a lithium nickel-based oxide represented by a formula of LiNi_{1-y}M_{y}O₂ (wherein M is Co, Mn, Al, Cu, Fe, Mg, B, Cr, Zn, or Ga and includes one or more selected from among the above elements, and 0.01≤y≤0.7), a lithium nickel cobalt manganese composite oxide represented by a formula of Li_{1+z}Ni_{b}Mn_{c}Co_{1-(b+c+d)}M_{d}O₍₂₋ₑ₎Aₑ such as Li_{1+z}Ni_{1/3}Co_{1/3}Mn_{1/3}O₂ or Li_{1+z}Ni_{0.4}Mn_{0.4}Co_{0.2}O₂ (wherein -0.5≤z≤0.5, 0.1≤b≤0.8, 0.1≤c≤0.8, 0≤d≤0.2, 0≤e≤0.2, b+c+d<1, M is Al, Mg, Cr, Ti, Si, or Y, and A is F, P, or Cl), and an olivine-based lithium metal phosphate represented by a formula of Li₁₊ₓM_{1-y}M'_{y}PO_{4-z}X_{z} (wherein M is a transition metal and is preferably Fe, Mn, Co, or Ni, M' is Al, Mg, or Ti, X is F, S, or N, -0.5≤x≤0.5, 0≤y≤0.5, and 0≤z≤0.1), but the present disclosure is not limited thereto.

Examples of the negative electrode active material include carbon such as non-graphitized carbon or graphite-based carbon, a metal complex oxide such as LiₓFe₂O₃ (0≤x≤1), LixWO₂ (0≤x≤1), or SnₓMe₁₋ₓMe'_{y}O_{z} (wherein Me is Mn, Fe, Pb, or Ge, Me' is Al, B, P, Si, a Group 1, 2 or 3 element in the Periodic Table, or a halogen, 0<x≤1, 1≤y≤3, and 1≤z≤8), a lithium metal, a lithium alloy, a silicon-based alloy, a tin-based alloy, a metal oxide such as SnO, SnO₂, PbO, PbO₂, Pb₂O₃, Pb₃O₄, Sb₂O₃, Sb₂O₄, Sb₂O₅, GeO, GeO₂, Bi₂O₃, Bi₂O₄, or Bi₂O₅, a conductive polymer such as polyacetylene, and a Li-Co-Ni-based material.

The conductive material is typically added in an amount of 1 wt% to 30 wt% based on the total weight of a mixture including the positive electrode active material. The conductive material is not particularly limited as long as the conductive material has high conductivity without causing a chemical change in a battery. Examples of the conductive material may include graphite such as natural graphite or synthetic graphite, carbon black such as carbon black, acetylene black, Ketjen black, channel black, furnace black, lamp black, or thermal black, a conductive fiber such as a carbon fiber or a metal fiber, a metal powder such as a carbon fluoride powder, an aluminum powder, or a nickel powder, conductive whiskey such as zinc oxide or potassium titanate, a conductive metal oxide such as titanium oxide, and a conductive material such as a polyphenylene derivative.

The binder may be a component for assisting with binding between a conductive material, an active material, and a current collector and may be typically included in an amount of 1 wt% to 30 wt% based on the total weight of a mixture including the negative electrode active material. Examples of the binder may include polyvinylidene fluoride, polyvinyl alcohol, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene terpolymer (EPDM), sulfonated-EPDM, styrene-butadiene rubber, fluorine rubber, and various polymers.

The filler is a component for controlling the expansion of an electrode and is selectively used. The filler is not particularly limited as long as the filler is a fibrous material that does not cause a chemical change in a battery. Examples of the filler may include an olefin-based polymer such as polyethylene or polypropylene, and a fibrous material such as a glass fiber or a carbon fiber.

Other components such as a viscosity modifier and an adhesion promoter may be added optionally or in a combination of two or more. The viscosity modifier is a component for adjusting the viscosity of an electrode mixture to facilitate mixing of the electrode mixture and coating thereof on a current collector and may be added up to 30 wt% based on the total weight of a negative electrode mixture. Examples of the viscosity modifier include carboxymethylcellulose, polyvinylidene fluoride, and the like, but the present disclosure is not limited thereto. In some cases, a solvent may also serve as the viscosity modifier.

The adhesion promoter is an auxiliary component added to enhance adhesion between an active material and a current collector and may be added in an amount of 10 wt% or less based on an amount of the binder. Examples of the adhesion promoter may include oxalic acid, adipic acid, formic acid, an acrylic acid derivative, and an itaconic acid derivative.

The separator is interposed between the positive electrode and the negative electrode, and an insulating ultra-thin film having high ion permeability and high mechanical strength is used. A pore diameter of the separator is generally in a range of 0.01 µm to 10 µm, and a thickness thereof is generally in a range of 5 µm to 300 µm. As the separator, for example, a sheet or non-woven fabric made of an olefin-based polymer such as polypropylene or a glass fiber or polyethylene, which has chemical resistance and hydrophobicity, is used.

The lithium salt-containing non-aqueous electrolyte includes an electrolyte and a lithium salt. As the electrolyte, a non-aqueous organic solvent, an organic solid electrolyte, an inorganic solid electrolyte, or the like is used.

Examples of the non-aqueous organic solvent may include an aprotic organic solvent such as N-methyl-2-pyrrolidinone, propylene carbonate, ethylene carbonate, butylene carbonate, dimethyl carbonate, diethyl carbonate, gamma-butyrolactone, 1,2-dimethoxy ethane, tetrahydrofuran, 2-methyl tetrahydrofuran, dimethylsulfoxide, 1,3-dioxolane, formamide, dimethylformamide, dioxolane, acetonitrile, nitromethane, methyl formate, methyl acetate, phosphoric acid triester, trimethoxy methane, a dioxolane derivative, sulfolane, methyl sulfolane, 1,3-dimethyl-2-imidazolidinone, a propylene carbonate derivative, a tetrahydrofuran derivative, ether, methyl propionate, or ethyl propionate.

Examples of the organic solid electrolyte may include a polyethylene derivative, a polyethylene oxide derivative, a polypropylene oxide derivative, a phosphoric acid ester polymer, poly agitation lysine, polyester sulfide, polyvinyl alcohol, polyvinylidene fluoride, and a polymer including an ionic dissociation group.

Examples of the inorganic solid electrolyte may include nitrides, halides, and sulfates of lithium (Li) such as Li₃N, LiI, Li₅NI₂, Li₃N-LiI-LiOH, LiSiO₄, LiSiO₄-LiI-LiOH, Li₂SiS₃, Li₄SiO₄, Li₄SiO₄-LiI-LiOH, and Li₃PO₄-Li₂S-SiS₂.

The lithium salt is a material that is readily soluble in the non-aqueous electrolyte. Examples thereof include LiCl, LiBr, LiI, LiClO₄, LiBF₄, LiB₁₀Cl₁₀, LiPF₆, LiCF₃SO₃, LiCF₃CO₂, LiAsF₆, LiSbF₆, LiAlCl₄, CH3SO₃Li, (CF₃SO₂)₂NLi, chloroborane lithium, lower aliphatic carboxylic acid lithium, lithium tetraphenyl borate, and imide.

In addition, in order to improve charge/discharge characteristics and flame retardancy, for example, pyridine, triethylphosphite, triethanolamine, cyclic ether, ethylenediamine, n-glyme, hexaphosphoric triamide, a nitrobenzene derivative, sulfur, quinone imine dye, N-substituted oxazolidinone, N,N-substituted imidazolidine, an ethylene glycol dialkyl ether, an ammonium salt, pyrrole, 2-methoxy ethanol, aluminum trichloride, or the like may be added to the electrolyte. In some cases, in order to impart incombustibility, the electrolyte may further include a halogen-containing solvent such as carbon tetrachloride or ethylene trifluoride. In addition, in order to improve high-temperature storage characteristics, the electrolyte may further include carbon dioxide gas, fluoro-ethylene carbonate (FEC), propene sultone (PRS), or the like.

In an exemplary example, a lithium salt such as LiPF₆, LiClO₄, LiBF₄, or LiN(SO₂CF₃)₂ is added to a mixed solvent of a cyclic carbonate of ethylene carbonate (EC) or propylene carbonate (PC) which is a high-dielectric solvent and a linear carbonate of diethyl carbonate (DEC), dimethyl carbonate (DMC), or ethyl methyl carbonate (EMC) which is a low viscosity solvent, thereby preparing the lithium salt-containing non-aqueous electrolyte.

In addition, the present disclosure provides a method of manufacturing a secondary battery for testing short circuit.

The content of the method of manufacturing a secondary battery for testing short circuit of the present disclosure may be partially in common with the above-described content of the secondary battery for testing short circuit, and the common content will be omitted.

In an example, the method of manufacturing a secondary battery according to the present disclosure includes forming a metal pattern layer on a region of one surface or both surfaces of a separator, covering the formed metal pattern layer with an insulating layer, which is made of a C₁₆ to C₄₀ paraffin-based compound, to form a short circuit induction member, and disposing the separator including the short circuit induction member between a positive electrode and a negative electrode.

The forming of the metal pattern layer includes forming a metal layer on the region of the one surface or both surfaces of the separator. The metal layer may be a metal layer formed on the separator before a pattern is formed and may be formed through a thin film deposition process typically applied in the related art. Examples of the thin film deposition process include an evaporation method, a chemical vapor deposition (CVD) method, a physical vapor deposition (PVD) method, and an atomic layer deposition (ALD) method. Specifically, examples of the CVD method include thermal CVD, plasma enhanced CVD (PECVD), atmospheric pressure CVD (APCVD), low pressure CVD (LPCVD), and the like. Examples of the PVD method include a thermal evaporation method, an e-beam evaporation method, a sputtering method, and the like.

Any one of the above-described methods of the deposition process may be used to deposit a metal on the separator of the present disclosure, and preferably, ALD may be used.

CVD has coverage and a moisture permeation prevention effect that are excellent but has a problem in that particles are generated during a relatively high temperature process and a process. PVD has an advantage in that a mechanism is simple, a safe process is implementable, and a process is performed at a low temperature but has a problem in that precision and bondability of a thin film are low. Meanwhile, ALD has an advantage that, by solving the problem of the low thin film application properties of existing CVD and PVD, a thin film in an atomic unit is grown, and the growing is repeated to finely control a thickness of the thin film. Therefore, as in the present disclosure, in order to form a metal layer to have a fine thickness, an ALD process method may be more preferable.

Next, the forming of the metal pattern layer may include applying a photoresist (PR) on the metal layer. The PR is a chemical substance of which properties change when the RP reacts to light and which is used in a photolithography process of forming a fine pattern. The PR may be classified as a positive PR in which a portion exposed to light is dissolved in a developer or a negative PR in which a portion not exposed to light is dissolved. In the present disclosure, any one selected from the positive PR and the negative PR may be used, and the positive PR may be preferably used. In addition, a soft baking process may be performed after the PR is applied. The soft baking process may increase adhesion between the PR and the metal layer.

Next, the forming of the metal pattern layer may include, after the applying of the PR on the metal layer, attaching a patterning mask. The patterning mask is attached to form a pattern on the metal layer, and a standard of the patterning mask may be determined according to a shape, area, or the like of the pattern of the metal layer. Since the patterning mask is not limited to a specific patterning mask, the patterning mask may be any one of conventionally used patterning masks.

Next, the forming a metal pattern layer may include performing an ultraviolet (UV) exposure process and a development process on the photoresist in a region where the patterning mask is attached. A (positive) PR in the region where the patterning mask is attached is not affected by exposure, but a material of a (positive) PR in a region where the patterning mask is not attached is changed due to exposure. After that, a developer may be applied to the region where the patterning mask is attached to change a material of the PR through exposure. In this case, the (positive) PR of which the material is changed is dissolved in a sensitizing solution, and then a cleaning process is performed. As a result, only the PR in the region where the patterning mask is attached may remain so that PR patterns may be formed.

Next, the forming a metal pattern layer may include etching the metal layer between the PR patterns. Since the etching is not particularly limited, the etching may be performed using a conventional etching process method. The forming a metal pattern layer may further include, before the etching, performing a hard baking process. The hard baking process is characterized by increasing adhesion between the PR and the metal layer and strengthening resistance to a subsequent etching process. Moreover, the forming a metal pattern layer may further include, after the etching, removing the patterning mask. Meanwhile, the etching may be performed after the removing of the patterning mask. Furthermore, the forming a metal pattern layer may further include, after the removing of the patterning mask, removing a PR remaining on the separator.

In addition, the present disclosure provides a method of evaluating safety of a secondary battery.

In an example, the method of evaluating safety of a secondary battery according to the present disclosure includes, first, providing the above-described secondary battery for testing short circuit, and applying an at least one of heat or external pressure to the secondary battery for testing short circuit to deform the separator in the region where the short circuit induction member is disposed.

The separator may be deformed by applying local heat to the separator including the short circuit induction member. In this case, a temperature of the applied heat may be changed according to a condition such as a constituent material, a type, a thickness, or the like of the separator, and when a heat of 130 °C to 180 °C is applied on average, the separator may be melted. In addition, external pressure (stress) may be applied to the separator including the short circuit induction member to cause deformation of the separator including the short circuit induction member, and in this case, the applied external pressure may be appropriately selected according to the characteristics of the separator. The external force may be applied to damage the separator including the short circuit induction member so that the short circuit induction member may be positioned between the separators.

In addition, the method may include melting an insulating layer of the short circuit induction member positioned between the separators to induce an internal short circuit of the secondary battery simultaneously or after a process of deforming the separator. As described above, the insulating layer according to the invention is made of a C₁₆ to C₄₀ paraffin-based compound that melts at a temperature of a melting point or more. A melting temperature may be determined according to a component or composition of the C₁₆ to C₄₀ paraffin-based compound, and the insulating layer may be melted at an average temperature of 40 °C to 80 °C. When a temperature is the melting temperature or more, the insulating layer covering a metal pattern layer melts, and the metal pattern layer is exposed. In this case, when a positive electrode and a negative electrode come into contact with the metal pattern layer, an internal short circuit may occur. In this case, the internal short circuit of the secondary battery may be evaluated by being adjusted to a fine level according to a density of a set metal pattern.

Hereinafter, a secondary battery for testing short circuit and a method of manufacturing the same according to the present disclosure are described in more detail with reference to the accompanying drawings.

While the present invention is open to various modifications and alternative embodiments, specific embodiments thereof are described and illustrated by way of example in the accompanying drawings.

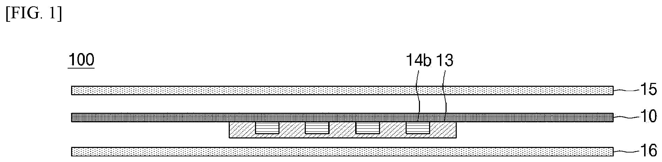

FIG. 1 is a schematic side view illustrating a secondary battery for testing short circuit which includes a short circuit induction member according to one embodiment of the present disclosure.

Referring to FIG. 1, a secondary battery 100 for testing short circuit according to the present disclosure may include a positive electrode 15, a negative electrode 16, and a separator 10 interposed between the positive electrode 15 and the negative electrode 16. The short circuit induction member including a metal pattern layer 14b and an insulating layer 13 is coupled to a region of the separator 10, that is, an internal short circuit test region.

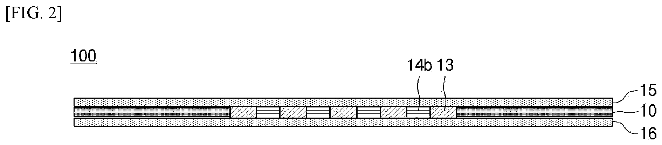

FIG. 2 is a schematic side view illustrating the secondary battery for testing short circuit in a state in which an internal short circuit is induced under a certain condition in the secondary battery for testing short circuit which includes the short circuit induction member according to one embodiment of the present disclosure.

Referring to FIG. 2, when heat or pressure is applied to a region of the separator 10 to which the short circuit induction member including the metal pattern layer 14b and the insulating layer 13 is coupled, the region of the separator 10 to which the short circuit induction member is coupled is fractured or damaged to be deformed so that the short circuit induction member is positioned between the separators 10. Meanwhile, when heat at a temperature of a melting point or more is applied to the insulating layer 13 of the short circuit induction member, the insulating layer 13 is melted so that the metal pattern layer 14b is exposed. In this case, when the exposed metal pattern layer 14b comes into contact with the positive electrode 15 and the negative electrode 16, an internal short circuit occurs.

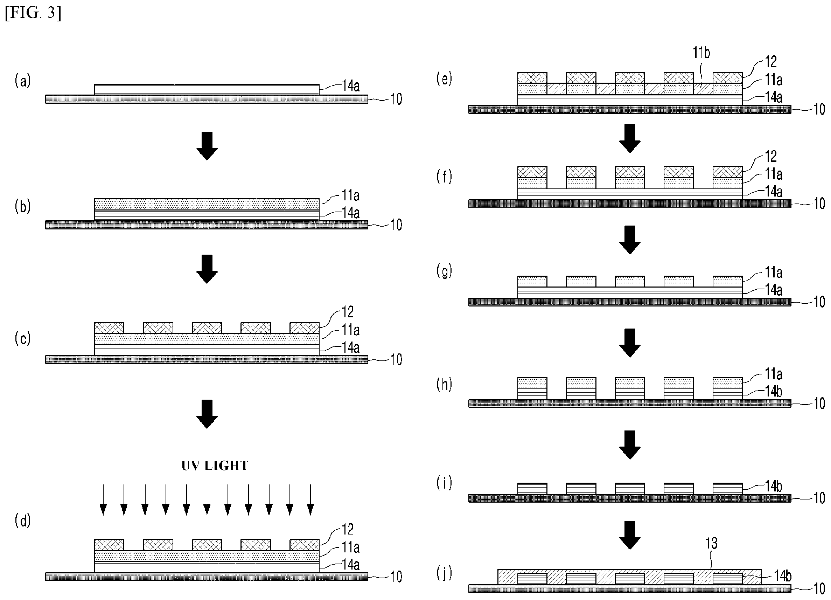

FIG. 3 shows schematic views sequentially illustrating processes of manufacturing a short circuit induction member according to one embodiment of the present disclosure.

Referring to FIG. 3(a), a region of a separator 10, that is, a region on which an internal short circuit of a battery is tested, is set, and a metal layer 14a is formed on the region through one method among conventional thin film deposition process methods such as CVD, PVD, and ALD methods.

Next, referring to FIG. 3(b), a positive PR 11a is applied on an upper surface of the metal layer 14a. Unlike a negative PR that is cured when exposed to light, when the positive PR 11a is exposed to light, solubility thereof is increased, and thus a material thereof is changed such that the positive PR can be melted in a developer later. In addition, a soft baking process may be performed after the PR 11a is applied. The soft baking process may increase adhesion between the PR 11a and the metal layer 14a.

Next, referring to FIG. 3(c), a patterning mask 12 is attached to a region on which the PR 11a is applied. The patterning mask 12 is finely patterned, and a region masked by the patterning mask 12 is not exposed to light, but an unmasked region is exposed to UV light. Meanwhile, a pattern width, an area, or the like of a pattern of the patterning mask 12 may be determined according to a purpose of forming a metal pattern layer.

Next, referring to FIGs. 3(d) and 3(e), when the tested region is exposed to UV light, the PR 11b not masked by the patterning mask 12 is exposed to the UV light so that a material thereof is changed to increase solubility in a developer.

Then, referring to FIGs. 3(f) and 3(g), a developer is added to the tested region to separate the PR 11b, of which the material is changed by exposure, from the metal layer 14a. In this case, the masked PR 11a is not separated from the metal layer 14a. After that, the patterning mask 12 is removed.

Next, referring to FIGs. 3(g) and 3(h), the metal layer 14a exposed by removing the PR 11b is etched to form a metal pattern layer 14b. In this case, an etching process may be performed through any one of conventional dry and wet processes, and in this case, a used solution or gas may be any one selected from among conventional materials. Meanwhile, a hard baking process may be further performed before the etching process (not shown). The hard baking process is characterized by increasing adhesion between the PR 11b and the metal layer 14a and strengthening resistance to a subsequent etching process.

Next, referring to FIGs. 3(i) and 3(j), the PR 11b covering the metal pattern layer 14b is removed, and an insulating layer 13 covering the metal pattern layer 14b from which the PR 11b is removed is applied. The insulating layer may include a conventional insulating function. A secondary battery for testing short circuit is manufactured using a short circuit induction member of the present disclosure which is a separator including the metal pattern layer 14b and the insulating layer 13, and heat or pressure is applied to a region in which the short circuit induction member of the secondary battery for testing short circuit is positioned to cause deformation such as damage to the separator 10 including the short circuit induction member (not shown). Then, when the insulating layer 13 is melted and the metal pattern layer 14b is bonded to a positive electrode 15 and a negative electrode 16, a short circuit occurs inside a secondary battery 100 for testing an internal short circuit.

### Description of Reference Numerals

10: separator
11a: photoresist before being exposed to light
11b: photoresist after being exposed to light
12: patterning mask
13: insulating layer
14a: metal layer
14b: metal pattern layer
15: positive electrode
16: negative electrode
100: secondary battery for testing short circuit

## Claims

1. A secondary battery for testing short circuit, the secondary battery comprising:
a positive electrode;
a negative electrode;
a separator between the positive electrode and the negative electrode; and
a short circuit induction member disposed on a region of one surface or both surfaces of the separator,
wherein the short circuit induction member has a structure including a metal pattern layer and an insulating layer, which is made of a C₁₆ to C₄₀ paraffin-based compound, applied on and covering the metal pattern layer.

2. The secondary battery of claim 1, wherein a formation area of the short induction member is in a range of 1 µm² to 1,000 mm².

3. The secondary battery of claim 1, wherein a pattern width of the metal pattern layer is in a range of 1 nm to 100 µm.

4. The secondary battery of claim 1, wherein a thickness of the metal pattern layer is in a range of 1% to 200% of a pattern width of the metal pattern layer.

5. The secondary battery of claim 1, wherein a thickness of the insulating layer is in a range of 101% to 200% of a thickness of the metal pattern layer.

6. The secondary battery of claim 1, wherein the metal pattern layer includes one or more selected from among aluminum, copper, and titanium.

7. A method of manufacturing a secondary battery for testing short circuit, the method comprising:
forming a metal pattern layer on a region of one surface or both surfaces of a separator;
covering the formed metal pattern layer with an insulating layer, which is made of a C₁₆ to C₄₀ paraffin-based compound, to form a short circuit induction member; and
disposing the separator including the short circuit induction member between a positive electrode and a negative electrode.

8. The method of claim 7, wherein the forming a metal pattern layer includes:
forming a metal layer on the region of the one surface or both surfaces of the separator, applying a photoresist on the metal layer, attaching a patterning mask, and then performing an exposure process and a development process on the photoresist in a region where the patterning mask is attached to form photoresist patterns; and
etching the metal layer between the photoresist patterns and removing the photoresist patterns.

9. A method of evaluating safety of a secondary battery, the method comprising:
applying at least one of heat or external pressure to the secondary battery for testing short circuit of claim 1 and deforming the region of the separator where the short circuit induction member is disposed; and
melting the insulating layer of the short circuit induction member and inducing an internal short circuit of the secondary battery.

## Patentansprüche

1. Sekundärbatterie zur Prüfung auf Kurzschlüsse, wobei die Sekundärbatterie umfasst:
eine positive Elektrode;
eine negative Elektrode;
einen Separator zwischen der positiven Elektrode und der negativen Elektrode; und
ein Kurzschluss-Induktionselement, das in einem Bereich einer Oberfläche oder beider Oberflächen des Separators angeordnet ist,
worin das Kurzschluss-Induktionselement eine Struktur aufweist, die eine Metallstrukturschicht und eine Isolierschicht beinhaltet, welche aus einer Verbindung auf Paraffinbasis mit C₁₆ bis C₄₀ ist, die auf die Metallstrukturschicht aufgebracht ist und diese bedeckt.

2. Sekundärbatterie gemäß Anspruch 1, worin ein Formationsbereich des Kurzschluss-Induktionselements in einem Bereich von 1 µm² bis 1.000 mm² liegt.

3. Sekundärbatterie gemäß Anspruch 1, worin eine Strukturbreite der Metallstrukturschicht in einem Bereich von 1 nm bis 100 µm liegt.

4. Sekundärbatterie gemäß Anspruch 1, worin eine Dicke der Metallstrukturschicht in einem Bereich von 1% bis 200% einer Strukturbreite der Metallstrukturschicht liegt.

5. Sekundärbatterie gemäß Anspruch 1, worin eine Dicke der Isolierschicht in einem Bereich von 101% bis 200% einer Dicke der Metallstrukturschicht liegt.

6. Sekundärbatterie gemäß Anspruch 1, worin die Metallstrukturschicht eines oder mehrere Elemente beinhaltet, ausgewählt aus Aluminium, Kupfer und Titan enthält.

7. Verfahren zur Herstellung einer Sekundärbatterie zur Prüfung auf Kurzschlüsse, wobei das Verfahren umfasst:
das Ausbilden einer Metallstrukturschicht auf einem Bereich einer Oberfläche oder beider Oberflächen eines Separators;
das Bedecken der ausgebildeten Metallstrukturschicht mit einer Isolierschicht, die aus einer Verbindung auf Paraffinbasis mit C₁₆ bis C₄₀ ist, um ein Kurzschluss-Induktionselement zu bilden; und
das Anordnen des Separators, der das Kurzschluss-Induktionselement beinhaltet, zwischen einer positiven Elektrode und einer negativen Elektrode.

8. Verfahren gemäß Anspruch 7, worin das Ausbilden einer Metallstrukturschicht umfasst:
das Ausbilden einer Metallschicht auf dem Bereich der einen Oberfläche oder beider Oberflächen des Separators, das Aufbringen eines Fotolacks auf die Metallschicht, das Anbringen einer Strukturierungsmaske und das anschließende Durchführen eines Belichtungs- und eines Entwicklungsprozesses an dem Fotolack in einem Bereich, in dem die Strukturierungsmaske angebracht ist, um Fotolackmuster auszubilden; und
das Ätzen der Metallschicht zwischen den Fotolackmustern und das Entfernen der Fotolackmuster.

9. Verfahren zur Bewertung der Sicherheit einer Sekundärbatterie, wobei das Verfahren umfasst:
das Anwenden von Wärme und/oder äußerem Druck auf die Sekundärbatterie zur Prüfung auf Kurzschlüsse gemäß Anspruch 1 und das Verformen des Bereichs des Separators, in dem das Kurzschluss-Induktionselement angeordnet ist; und
das Schmelzen der Isolierschicht des Kurzschluss-Induktionselements und Herbeiführen eines internen Kurzschlusses der Sekundärbatterie.

## Revendications

1. Batterie secondaire pour essai de court-circuit, la batterie secondaire comprenant :
une électrode positive ;
une électrode négative ;
un séparateur entre l'électrode positive et l'électrode négative ; et
un élément d'induction de court-circuit disposé sur une région d'une surface ou des deux surfaces du séparateur,
dans laquelle l'élément d'induction de court-circuit présente une structure incluant une couche de motif métallique et une couche isolante, qui est faite d'un composé à base de paraffine en C₁₆ à C₄₀, appliquée sur la couche de motif métallique et la recouvrant.

2. Batterie secondaire selon la revendication 1, dans laquelle une surface de formation de l'élément d'induction de court-circuit est dans une plage de 1 µm² à 1 000 mm².

3. Batterie secondaire selon la revendication 1, dans laquelle une largeur du motif de la couche de motif métallique est dans une plage de 1 nm à 100 µm.

4. Batterie secondaire selon la revendication 1, dans laquelle une épaisseur de la couche de motif métallique est dans une plage de 1 % à 200 % d'une largeur du motif de la couche de motif métallique.

5. Batterie secondaire selon la revendication 1, dans laquelle une épaisseur de la couche isolante est dans une plage de 101 % à 200 % d'une épaisseur de la couche de motif métallique.

6. Batterie secondaire selon la revendication 1, dans laquelle la couche de motif métallique inclut un ou plusieurs éléments sélectionnés parmi l'aluminium, le cuivre et le titane.

7. Procédé de fabrication d'une batterie secondaire pour essai de court-circuit, le procédé comprenant les étapes consistant à :
former une couche de motif métallique sur une région d'une surface ou des deux surfaces d'un séparateur ;
recouvrir la couche de motif métallique formée d'une couche isolante, qui est faite d'un composé à base de paraffine en C₁₆ à C_{4Q}, pour former un élément d'induction de court-circuit ; et
disposer le séparateur incluant l'élément d'induction de court-circuit entre une électrode positive et une électrode négative.

8. Procédé selon la revendication 7, dans lequel le fait de former une couche de motif métallique inclut les étapes consistant à :
former une couche métallique sur la région de l'une des surfaces ou des deux surfaces du séparateur, appliquer un photorésist sur la couche métallique, fixer un masque à motif, et ensuite réaliser un procédé d'exposition et un procédé de développement sur le photorésist dans une région où le masque à motif est fixé pour former des motifs de photorésist ; et
graver la couche métallique entre les motifs de photorésist et retirer les motifs de photorésist.

9. Procédé d'évaluation de la sécurité d'une batterie secondaire, le procédé comprenant les étapes consistant à :
appliquer au moins l'une de la chaleur ou de la pression externe à la batterie secondaire pour essai de court-circuit selon la revendication 1 et déformer la région du séparateur dans laquelle l'élément d'induction de court-circuit est disposé ; et
faire fondre la couche isolante de l'élément d'induction de court-circuit et induire un court-circuit interne de la batterie secondaire.
